# EUROPEAN PATENT APPLICATION

(11) **EP 4 498 423 A1**
(43) Date of publication of application: **29.01.2025**
(21) Application number: 24188542.5
(22) Date of filing: 15.07.2024
(51) Int. Cl.: H01L 21/8258, H01L 21/02, H01L 27/06, H01L 27/085

(54) **MANUFACTURING PROCESS OF A SEMICONDUCTOR ELECTRONIC DEVICE INTEGRATING DIFFERENT ELECTRONIC COMPONENTS AND SEMICONDUCTOR ELECTRONIC DEVICE**

(30) Priority: 27.07.2023 IT 202300015876
(71) Applicant: STMicroelectronics International N.V., 1228 Plan-les-Ouates, Geneva (CH)
(72) Inventor: DEPETRO, Riccardo, 28845 DOMODOSSOLA (VB) (IT)
(74) Representative: Studio Torta S.p.A.

(57) **Abstract**

To manufacture a semiconductor electronic device (1) a wafer (100) is provided that has a substrate layer (18) of semiconductor material having a first portion (101A) and a second portion (101B) distinct from the first portion. An epitaxial region (23, 106) of a single semiconductor material is grown on the first portion (101A) of the substrate layer. An epitaxial multilayer (49, 114) having a heterostructure (50) is grown on the second portion (101B) of the substrate layer. A first electronic component (5A, 5B, 5C, 5D) based upon the single semiconductor material is formed starting from the epitaxial region (23, 106) and a second electronic component (7) based upon a heterostructure is formed starting from the heterostructure. To grow an epitaxial multilayer, a growth mask (103) is formed on the substrate layer (18); an opening is made in the growth mask (103), thereby exposing the second portion of the substrate layer; and the epitaxial multilayer is grown on the second portion of the substrate layer.

## Description

### Technical field

The present invention relates to a manufacturing process of a semiconductor electronic device integrating different electronic components and to a semiconductor electronic device.

### Background

Semiconductor electronic devices are known that comprise silicon-based active and/or passive electronic components, for example CMOS transistors, DMOS transistors, BJTs, diodes, resistors, etc., that are integrated in a same silicon die and obtained, for example, via BCD (Bipolar-CMOS-DMOS) technology.

In practice, operation of such electronic components is based upon the electronic properties of a single semiconductor material (silicon).

Said devices integrate monolithically, in the same die, digital circuits, analog circuits and power circuits that work at voltages very different from one another, for example from a few volts in the case of CMOS transistors used for implementation of logic functions, up to hundreds of volts in the case of DMOS transistors used for power applications.

The silicon-based electronic components are integrated in a monocrystalline silicon region grown on a <100> silicon wafer.

Semiconductor electronic devices are also known comprising heterostructure-based electronic components, for example HEMTs (High-Electron-Mobility Transistors).

In practice, operation of such electronic components is based upon the electronic properties of a heterojunction between two different semiconductor materials.

In detail, in HEMTs, the conductive channel is based upon formation of layers of two-dimensional electron gas (2DEG) with high-mobility electrons that form at a heterojunction, i.e., at the interface between semiconductor materials that have different band gaps. For instance, HEMTs are known based upon the heterojunction between a layer of aluminium and gallium nitride (AlGaN) and a layer of gallium nitride (GaN).

HEMT devices, in particular ones based upon AlGaN/GaN heterojunctions or heterostructures, have a wide range of advantages that make them particularly suited and widely used for different applications. For instance, the high-breakdown threshold of HEMT devices is exploited for high-performance power switches; the high mobility of the electrons in the conductive channel enables to obtain highfrequency amplifiers; further, the high concentration of electrons in the 2DEG allows to obtain a low ON-state resistance (R_{ON}).

Further, HEMT devices for radiofrequency (RF) applications typically provide better RF performance than similar silicon LDMOS devices.

The heterostructure-based electronic components are integrated in a heterostructure grown epitaxially on a <111> silicon wafer, or else on a substrate of sapphire (Al₂O₃) or silicon-carbide (SiC).

In order to obtain a good crystallographic quality of the respective epitaxial regions, and thus good electrical performance of the corresponding electronic components, the heterostructure-based electronic components and the silicon-based electronic components are integrated in dice that are distinct from one another, starting from two different silicon wafers.

However, this means that an electronic apparatus that incorporates both silicon-based components and heterostructure-based components has a large occupation of area and consequently a high manufacturing cost, a high energy consumption, and low electrical performance, for example due to the parasitic capacitances introduced by the electrical connections between dice.

According to one approach, the die wherein the silicon-based components are formed, and the die wherein the heterostructure-based components are formed are bonded on top of one another via a die-transfer technology.

However, also the above approach has disadvantages in terms of manufacturing costs and reliability and in terms of electrical performance, in use.

### Summary

According to the present invention, a manufacturing process of a semiconductor electronic device and a semiconductor electronic device are consequently provided, as defined in the annexed claims.

### Brief description of the drawings

For a better understanding of the present invention, embodiments thereof are now described, purely by way of non-limiting example, with reference to the attached drawings, wherein:
- Figure 1 is a cross-sectional view of a semiconductor electronic device, according to one embodiment;
- Figure 2 shows a top plan view of the device of Figure 1; and
- Figures 3A-3N are cross-sectional views of the device of Figure 1 in successive manufacturing steps.

### Description of embodiments

The following description refers to the arrangement illustrated in the attached figures. Consequently, terms such as "above", "underneath", "top", "bottom", "right", "left", "high", "low", and the like, regard the annexed figures and are not to be interpreted in a limiting way.

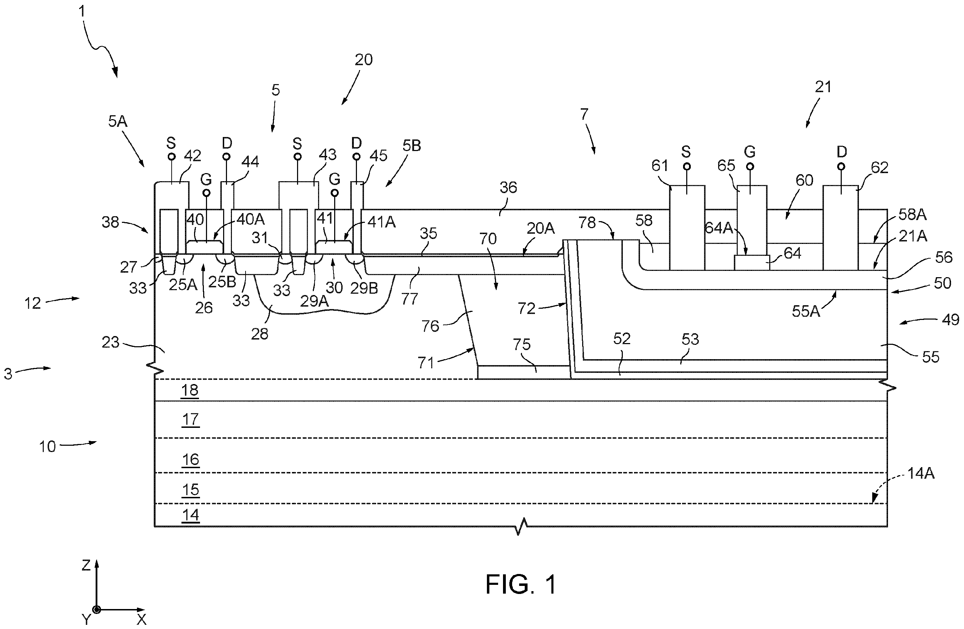

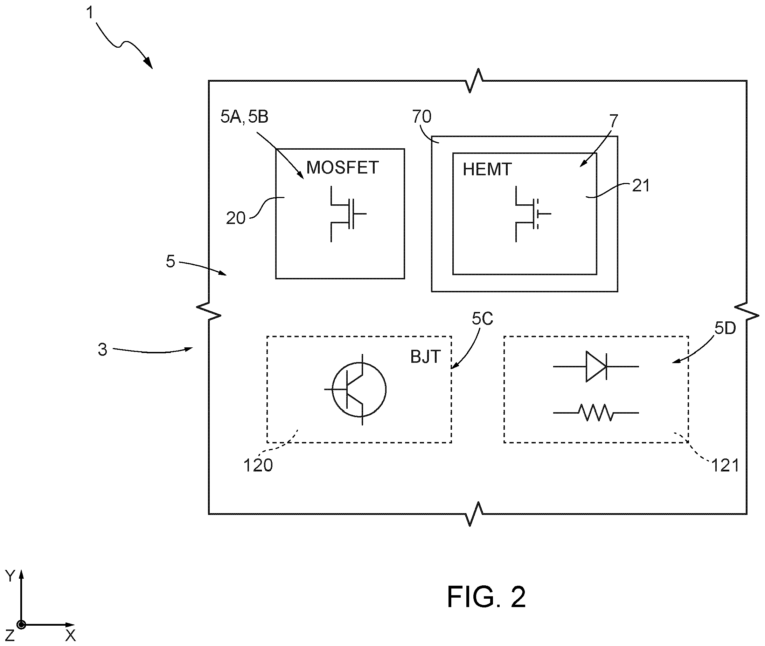

Figures 1 and 2 show a semiconductor electronic device (referred to hereinafter simply as device) 1, in a cartesian reference system XYZ having a first axis X, a second axis Y, and a third axis Z.

The device 1 is formed in a die 3 and comprises one or more silicon-based electronic components 5, of which a PMOS transistor 5A and an NMOS transistor 5B are illustrated in Figure 1, and one or more heterostructure-based electronic components, of which a HEMT 7 is illustrated in Figure 1, all integrated in the die 3.

The die 3 comprises a substrate region 10 and a surface region 12 that extends on, in particular in direct contact with, the substrate region 10.

The substrate region 10 comprises a substrate 14 and one or more epitaxial layers arranged on the substrate 14.

The substrate 14 is made of semiconductor material, in particular monocrystalline semiconductor material, and has a top surface 14A.

In detail, in this embodiment the substrate 14 is made of monocrystalline silicon, and, in particular, the top surface 14A is oriented according to the crystallographic direction <111>.

In this embodiment, the substrate region 10 comprises: a first epitaxial layer, or first deep layer 15, overlying the top surface 14A of the substrate 14; a second epitaxial layer, or first intermediate layer 16, overlying the first deep layer 15; a third epitaxial layer, or second deep layer 17, overlying the first intermediate layer 16; and a fourth epitaxial layer, or second intermediate layer 18, overlying the second intermediate layer 17.

The epitaxial layers 15-18 are made of semiconductor material, in particular the same as that of the substrate 14 (here silicon), and are identified for clarity by dashed lines in Figure 1.

The thickness along the third axis Z, the conductivity type (e.g., P or N) and the doping profile of the substrate 14 and of the epitaxial layers 15-18 may be chosen, in the design stage, according to the specific application of the device 1.

For instance, the epitaxial layers 15-18 may each have a thickness comprised between 0.1 µm and 7 µm.

For instance, in this embodiment, the substrate 14 is of a P type, for example with a resistivity comprised between 0.1 Ω·cm and 20 Ω·cm, and the epitaxial layers 15-18 are of an N type. In this way, the first deep layer 15 may create, with the substrate 14a, PN junction, which, in use, may be employed for insulating the devices 5, 7 integrated in the die 3 from the substrate 14.

The first and second deep layers 15, 17 may have a doping level that is the same as or different from, in particular higher than, that of the first and second intermediate layers 16, 18. For instance, the doping level of the first and second deep layers 15, 17 may be comprised between 0.1 Ω·cm and 20 Ω·cm, and the doping level of the first and second intermediate layers 16, 18 may be comprised between 0.1 Ω·cm and 20 Ω·cm.

A high doping level of the first deep layer 15 entails that, in use, the depleted region between the first deep layer 15 and the substrate 14 extends mainly in the substrate 14, thus improving the electrical insulation of the components 5,7 from the substrate 14.

Furthermore, the high doping level of the first deep layer 15 may allow to employ, in use, the first deep layer 15 as current-conduction region of the electronic components integrated in the die 3, for example if the silicon-based components 5 include BJT transistors.

The presence both of the first deep layer 15 and of the second deep layer 17 may be useful for simplifying manufacture of the device 1 and for obtaining, in use, excellent electrical performance of the device 1, in the case where the electronic components 5, 7 are designed for operating at high voltages with respect to the substrate 14, for example for operating properly with a voltage of 5 V applied at the respective terminals referenced to positive voltages starting from approximately 20 V, for example 60 V, 100 V, or 650 V, with respect to the substrate 14, according to the specific application and to the type of doping used.

The surface region 12 extends on the second intermediate layer 18, in particular in direct contact therewith, and comprises a first device portion 20, wherein the PMOS transistor 5A and the NMOS transistor 5B are integrated, and a second device portion 21, wherein the HEMT 7 is integrated.

The first device portion 20 has a top surface 20A and comprises an epitaxial region 23 made of semiconductor material, in particular the same material as that of the second intermediate layer 18, here monocrystalline silicon.

The epitaxial region 23 extends from the second intermediate layer 18, in particular here in direct contact therewith, to the top surface 20A.

The thickness along the third axis Z, the conductivity type (e.g., P or N) and the doping profile of the epitaxial region 23 may be chosen, in the design stage, according to the specific application of the device 1.

For instance, in this embodiment the epitaxial region 23 is of an N type.

The first device portion 20 comprises a plurality of doped regions that extend within the epitaxial region 23 and form functional regions of the silicon-based electronic components 5.

In detail, in the embodiment of Figure 1, doped regions 25A, 25B of a P++ type extend within the epitaxial region 23 from the top surface 20A. The doped regions 25A, 25B form the source region and the drain region, respectively, of the PMOS transistor 5A and delimit a channel region 26 of the PMOS transistor 5A.

Furthermore, a doped region 27 of an N++ type extends into the epitaxial region 23 from the top surface 20A and forms a body-contact region of the PMOS transistor 5A.

Still with reference to the embodiment of Figure 1, a doped region 28 of a P type extends into the epitaxial region 23 from the top surface 20A and forms the body region of the NMOS transistor 5B.

Doped regions 29A, 29B of an N++ type extend within the doped region 28 and form the source region and the drain region, respectively, of the NMOS transistor 5B, and delimit a channel region 30 of the NMOS transistor 5B.

Furthermore, a doped region 31 of a P++ type extends within the doped region 28 and forms a body-contact region of the NMOS transistor 5B.

In practice, the doped regions 25A, 25B, 27, 29A, 29B, and 31, that is the doped source and drain regions, and the body-contact regions, are highly doped regions, with a doping level comprised, for example, between 5·10¹⁹ atoms/cm³ and 5·10²⁰ atoms/cm³ as peak concentration. Instead, the doped region 28, that is the body region, is a low-doping region, with a doping level comprised, for example, between 1·10¹⁶ atoms/cm³ and 2·10¹⁸ atoms/cm³ as peak concentration.

The number, arrangement, shape, size, and doping profile of the doped regions may be chosen, in the design stage, according to the specific silicon-based electronic components 5 integrated in the die 3 and the specific application of the device 1.

Insulating portions 33 made of insulating material, for example oxide, may extend, according to the specific application, into the epitaxial region 23 from the top surface 20A.

In particular, in Figure 1, the insulating portions 33 extend parallel to the first axis X between the doped regions 27 and 25A, 25B and 31, 31 and 29A.

A first insulating layer 35, for example an oxide or nitride layer, extends on the top surface 20A of the first device portion 20.

A second insulating layer 36, for example an oxide layer, extends on the first insulating layer 35.

Surface structures 38 of the silicon-based components 5 extend on the top surface 20A of the first device region 20, in direct contact therewith. The surface structures 38 form further functional regions of the silicon-based devices 5 and may include various conductive and/or insulating regions, according to the specific silicon-based electronic components 5 integrated in the die 3.

In this embodiment, the surface structures 38 comprise insulated-gate regions 40, 41, which extend, respectively, over the channel region 26 of the PMOS transistor 5A and over the channel region 30 of the NMOS transistor 5B. Of the insulated-gate regions 40, 41, in Figure 1, only the respective conductive regions, here polysilicon regions, are illustrated for simplicity and are still designated by 40, 41, each having a respective top surface 40A, 41A.

Albeit not illustrated in Figure 1, the insulated-gate regions 40, 41 may each comprise also a respective insulating region arranged between the respective polysilicon region and the top surface 20A and a respective contact region made of conductive material, for example a metal, in contact with the respective surface 40A, 41A and forming a respective gate terminal G.

In the embodiment of Figure 1, the surface structures 38 also comprise source-contact regions 42, 43 and drain-contact regions 44, 45, made of conductive material, which extend through the first and second insulating layers 35, 36, in direct contact with the top surface 20A, thus forming respective source terminals S and drain terminals D.

In detail, the source-contact regions 42, 43 extend in direct contact with the source region 25A of the PMOS transistor 5A and with the source region 29A of the NMOS transistor 5B, respectively.

Furthermore, in the embodiment illustrated, the source-contact regions 42, 43 extend each in direct contact also with the respective body contact region 27, 31.

The drain-contact regions 44, 45 extend in direct contact with the drain region 25B of the PMOS transistor 5A and with the drain region 29B of the NMOS transistor 5B, respectively.

The second device portion 21 of the surface region 12 has a top surface 21A and comprises an epitaxial multilayer 49 that extends on the second intermediate layer 18 and is grown starting therefrom.

The epitaxial multilayer 49 comprises a heterostructure 50 wherein the HEMT 7 is integrated.

In the embodiment of Figure 1, the epitaxial multilayer 49 also comprises a transition region formed here by a first buffer layer 52 and a second buffer layer 53 overlying one another, which are arranged between the second intermediate layer 18 and the heterostructure 50. The transition region may be useful during manufacture of the device 1 to favour epitaxial growth of the heterostructure 50 on the second intermediate layer 18.

In detail, the first buffer layer 52, for example of aluminium nitride (AlN), extends on, and in direct contact with, the second intermediate layer 18, and the second buffer layer 53, for example of aluminium and gallium nitride (AlGaN), extends on, and in direct contact with, the first buffer layer 52.

The heterostructure 50 comprises compound semiconductor materials that include elements of Groups III and V of the Periodic Table and forms the top surface 21A of the second device portion 21.

The top surface 21A of the second device portion 21 may extend at a coordinate along the third axis Z that is the same as or different from that at of the top surface 20A of the first device portion 20, according to the specific manufacturing steps used for manufacturing the device 1.

In particular, in this embodiment, the top surface 21A of the second device portion 21 is arranged at a lower height, measured along the third axis Z, than the top surface 20A of the first device portion 20. This allows to improve manufacturing of the device 1.

The heterostructure 50 comprises a channel layer 55 and a barrier layer 56 overlying one another.

The channel layer 55 is of a first semiconductor material, for example gallium nitride (GaN) or an alloy comprising gallium nitride, such as InGaN, here gallium nitride (GaN), extends onn the transition region, in particular on the second buffer layer 53, and has a top surface 55A.

The barrier layer 56 is of a second semiconductor material, for example a compound based upon a ternary or quaternary alloy of gallium nitride, such as AlₓGa₁₋ₓN, AlInGaN, InₓGa₁₋ₓN, AlₓIn₁₋ₓAl, AlScN, here aluminium and gallium nitride (AlGaN), extending between the top surface 55A of the channel layer 55 and the top surface 21A of the second device portion 21.

The channel layer 55 and the barrier layer 56 may be intrinsic, P or N type, according to the specific application; in particular, both the channel layer 55 and the barrier layer 56 may be of N type.

For instance, when the barrier layer 56 is of AlGaN, the presence of aluminium atoms may cause the barrier layer 56 to be of N type.

The heterostructure 50 is configured to house a two-dimensional gas of (mobile) charge carriers, in particular here electrons (2DEG), which is arranged at the interface between the channel layer 55 and the barrier layer 56, i.e., at the top surface 55A of the channel layer 55.

An insulating layer 58 having a top surface 58A, for example of an oxide such as silicon oxide, extends on the top surface 21A. The insulating layer 58 may have a thickness comprised, for example, between 20 nm and 1 pm.

The insulating layer 36 also extends on the second device portion 21, in particular over the insulating layer 58.

Surface structures 60 of the heterostructure-based components 7 extend on the top surface 21A of the second device portion 21.

The surface structures 60 may be various conductive and/or insulating regions, according to the specific heterostructure-based electronic components 7 integrated in the die 3, which form functional regions of the heterostructure-based components 7.

In this embodiment, where the heterostructure-based electronic component 7 is a HEMT, the surface structures 60 comprise a source region 61 and a drain region 62, of conductive material, extending at a distance from one another along the first axis X.

The source region 61 and the drain region 62 are in electrical contact, in particular ohmic contact, with the heterostructure 50, in particular with the two-dimensional gas that forms at the interface between the channel layer 55 and the barrier layer 56, and form, respectively, a source terminal S and a drain terminal D of the HEMT 7.

In the embodiment of Figure 1, the source and drain regions 61, 62 extend, parallel to the third axis Z, through the insulating layers 36, 58 up to the top surface 21A.

However, the source and drain regions 61, 62 may extend, parallel to the third axis Z, partially also through the heterostructure 50, for example through part of the barrier layer 56 or throughout the thickness of the barrier layer 56 up to the surface 55A, according to the specific application.

The surface structures 60 also comprise a gate structure, here formed by a channel-modulation region 64 and a gate-contact region 65, which may be biased to control electrically the formation of the two-dimensional gas in the heterostructure 50 between the source region 61 and the drain region 62. The gate structure forms a gate terminal G of the HEMT 7.

In this embodiment, the HEMT 7 is normally off, i.e., of the enrichment type.

In detail, in this embodiment, the channel-modulation region 64 is of semiconductor material and has a conductivity type different from that of the barrier layer 56, for example of P type. In particular, the channel-modulation region 64 may be made of P-type gallium nitride (p-GaN) .

However, the channel-modulation region 64 may be formed by an ensemble of different materials that include dielectric layers, metal layers, and/or semiconductor layers used as control electrodes with appropriate work function.

The channel-modulation region 64 extends on the top surface 21A, between the source region 61 and the drain region 62 along the first axis X, and has a top surface 64A.

The top surface 64A of the channel-modulation region 64 may extend at a coordinate along the third axis Z that is the same as or different from that at which the top surface 40A, 41A of the insulated-gate regions 40, 41 extends, according to the specific manufacturing steps used for producing the device 1.

In particular, in this embodiment, the top surface 64A of the channel-modulation region 64 is arranged at a distance from the second intermediate layer 18, measured along the third axis Z, smaller than the distance, measured along the third axis Z, of the top surface 40A, 41A of the insulated-gate regions 40, 41 from the second intermediate layer 18. This may enable increase of the manufacturing reliability of the device 1.

The gate-contact region 65, of conductive material, extends in electrical contact with the channel-modulation region 64, in particular here in contact with the top surface 64A.

The surface region 12 of the die 3 further comprises also a residual separation portion 70 that extends on the second intermediate layer 18, in direct contact therewith, between the first and the second device portions 20, 21.

As may be seen in the schematic top plan view of Figure 2, the residual separation portion 70 surrounds the second device portion 21.

Once again with reference to Figure 1, the residual separation portion 70 has a top surface that, in this embodiment, is continuous with, in particular aligned to, the top surface 20A of the first device portion 20 and consequently is designated by the same reference number.

The residual separation portion 70 is laterally contiguous, parallel to the first axis X, with the second device portion 21.

In detail, the residual separation portion 70 has a first side wall 71 contiguous with the first device portion 20 and a second side wall 72 opposite to the first side wall 71 and contiguous with the second device portion 21.

The residual separation portion 70 comprises a definition region 75, for example comprising an oxide, in particular silicon oxide, which extends on, and in direct contact with, the second intermediate layer 18; and a polycrystalline region 76, of the same material (silicon) as the epitaxial region 23 of the first device portion 20, which extends o, and in direct contact with, the definition region 75.

The definition region 75 may be formed by a single layer, for example an oxide layer, in particular a silicon-oxide layer, or else by a multilayer comprising, for instance, one or more layers of an oxide and/or one or more layers of a nitride.

In detail, according to one embodiment, the definition region 75 may be made of silicon oxide.

According to a different embodiment, the definition region 75 may comprise an oxide layer, in particular a silicon-oxide layer, and a nitride layer.

According to one embodiment, the oxide layer may be in direct contact with the semiconductor layer 18.

The definition region 75 may have a thickness, along the third axis Z, comprised for example between 7 nm and 300 nm, in particular between 70 Å and 200 Å.

In this embodiment, the polycrystalline region 76 has a polycrystalline structure.

In this embodiment, the polycrystalline region 76 is monolithic with the epitaxial region 23.

The inclination of the first side wall 71 may depend upon the crystal orientation of the epitaxial region 23 and upon the thickness along the third axis Z of the definition region 75. For instance, in the case where the epitaxial region 23 is oriented according to the crystallographic direction <111>, the first side wall 71 may form an angle of approximately 54° with a direction parallel to the first axis X.

The polycrystalline region 76 extends at a distance from the top surface 20A.

An insulation region 77 of insulating material, for example oxide, extends in the die 3, from the top surface 20A, between the first and second device portions 20, 21.

In detail, the insulation region 77 extends, parallel to the third axis Z, in the first device portion 20 from the top surface 20A within the epitaxial region 23 and, in the residual separation portion 70, between the top surface 20A and the polycrystalline region 76.

In the embodiment of Figure 1, the epitaxial multilayer 49 comprises a portion that extends, conformably, on the second side wall 72 of the residual separation portion 70, forming a raised surface 78.

The raised surface 78 is arranged at a coordinate along the third axis Z higher than that of the top surface 21A and, here, also higher than the top surface 58A of the insulating layer 58 extends.

Shape and structure of the residual separation portion 70 may vary according to the specific manufacturing steps used for manufacturing the device 1.

The presence of a polycrystalline region (region 76) between the epitaxial multilayer (21) and the epitaxial region (23) may be useful for reducing the stress caused by the lattice mismatch between the materials that form the epitaxial multilayer (e.g., GaN) and the material that forms the epitaxial region (e.g., silicon). Consequently, the presence of the polycrystalline region may contribute to the reduction of the risk of dislocations in the die 3 (and thus possible failure of the device 1).

The device 1 allows to combine, in a single die, the functions of the silicon-based components 5 and of the heterostructure-based components 7, maintaining smaller dimensions with respect to an electronic device wherein the silicon-based components 5 and the heterostructure-based components 7 are integrated in dice different from one another.

Furthermore, the electrical connection between the silicon-based components 5 and the heterostructure-based components 7 may be obtained directly on the die 3. This may guarantee high electrical performance, in use, of the device 1, for example, in terms of switching speed of the various components, of minimal resistive losses in the electrical connections between them, and of minimal effects of overvoltages due to the presence of parasitic inductances.

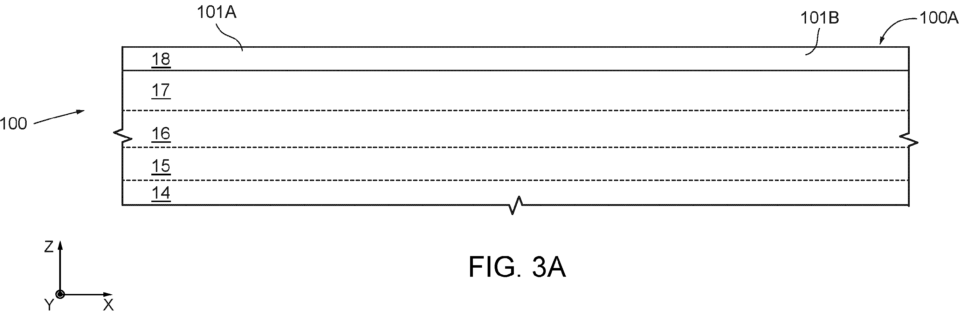

Hereinafter, with reference to Figures 3A-3N, steps for manufacturing the semiconductor electronic device 1 are described.

Figure 3A shows a cross-section of a wafer 100 of monocrystalline semiconductor material, in particular silicon, having a top surface 100A. Elements of the wafer 100 common to those already described with reference to Figure 1 are designated by the same reference numbers and are not described in detail any further.

The wafer 100 comprises the substrate 14, on which the epitaxial layers 15, 16, 17, and 18 have already been grown.

The fourth epitaxial layer, or second intermediate layer, 18 forms the top surface 100A of the wafer 100.

The second intermediate layer 18 comprises a first portion 101A on which the first device portion 20 is intended to be formed, i.e., the PMOS transistor 5A and NMOS transistor 5B are to be integrated; and a second portion 101B on which the second device portion 21 is intended to be formed, i.e., on which the epitaxial multilayer 49 is to be grown and the HEMT 7 is to be integrated.

The first portion 101A is arranged laterally to the second portion 101B, in particular on a side along the first axis X in the shown embodiment.

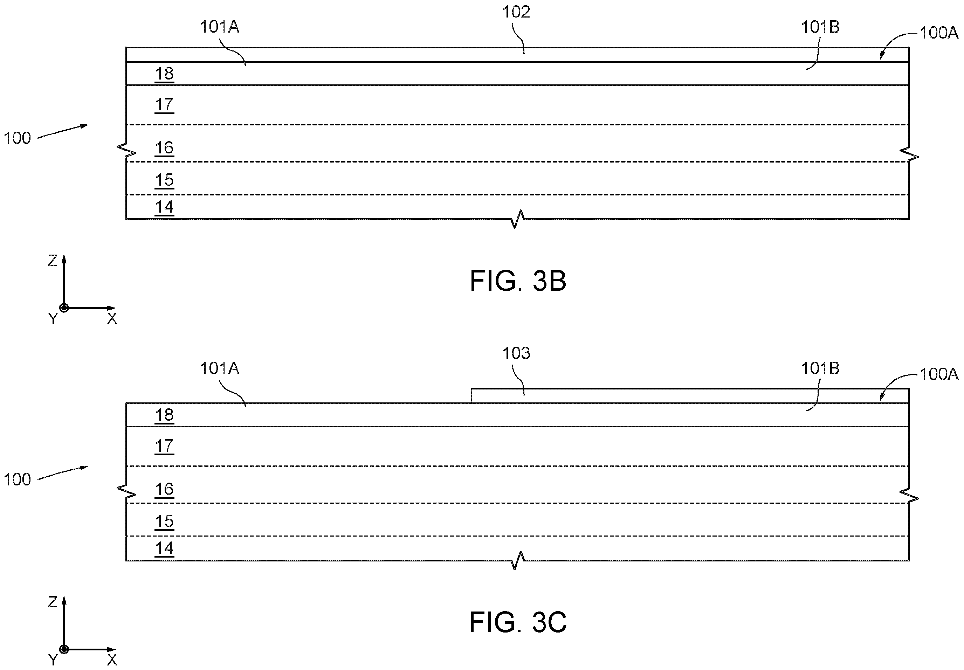

Next (Figure 3B), a definition layer 102, for example comprising an oxide, in particular silicon oxide, is formed on the top surface 100A.

The definition layer 102 may be formed by one or more layers of different materials, as discussed for the definition region 75 of Figure 1.

The definition layer 102 may have a small thickness along the third axis Z, comprised for example between 7 nm and 300 nm, in particular from 70 Å to 200 Å.

The definition layer 102 is intended to form the definition region 75 (Figure 1).

The definition layer 102 may be formed via oxidation of a surface portion of the second intermediate layer 18, or else via deposition on the top surface 100A. In the case of oxidation, the thickness of the second intermediate layer 18 may be reduced, following upon oxidation, as compared to that of the layer 18 of Figure 3A. However, given the much smaller thickness of the definition layer 102 as compared to the thickness of the second intermediate layer 18, it may be assumed for simplicity that the thickness of the second intermediate layer 18 will remain, to a first approximation, the same before and after oxidation.

Then (Figure 3C), the definition layer 102 is removed at the first portion 101A of the second intermediate layer 18 (on which the first device portion 20 is intended to be formed), i.e., the portion of the second intermediate layer 18 on which the epitaxial region 23 is intended to be formed. Thus, of the definition layer 102, a portion remains also referred to hereinafter as growth mask 103.

In practice, the growth mask 103 exposes the first portion 101A of the second intermediate layer 18 and covers the second portion 101B of the second intermediate layer 18.

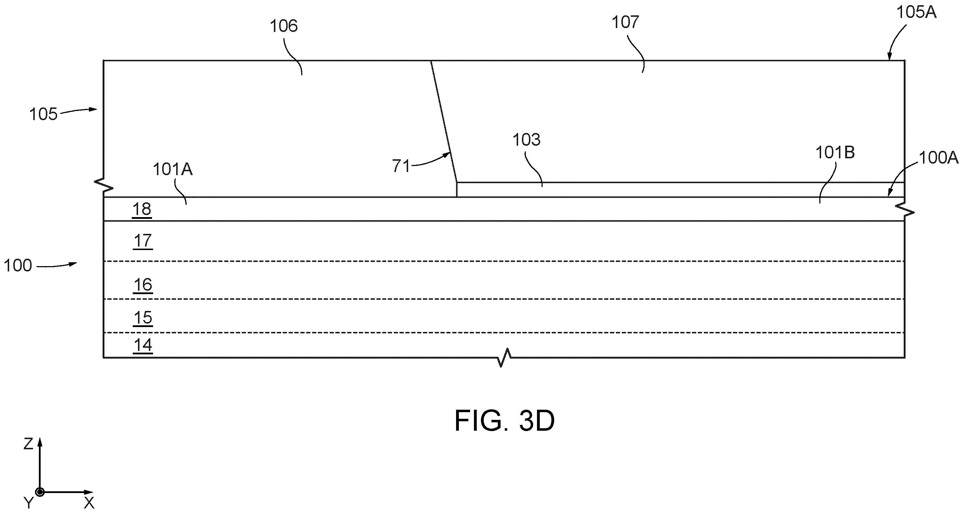

In Figure 3D, a surface layer 105 of semiconductor material, in particular the same material as that of the second intermediate layer 18 (here silicon), is grown on the wafer 100.

The surface layer 105 has a top surface 105A.

The surface layer 105 comprises an epitaxial portion 106 that grows parallel to the third axis Z from the second intermediate layer 18, in particular from the respective first portion 101A, and a sacrificial portion 107 that grows parallel to the third axis Z on the growth mask 103.

The epitaxial portion 106, which grows from a monocrystalline substrate, maintains the monocrystalline structure of the second intermediate layer 18 and is intended to form the epitaxial region 23 of the first device portion 20.

The sacrificial portion 107, which grows from a non-crystalline substrate, has a polycrystalline structure.

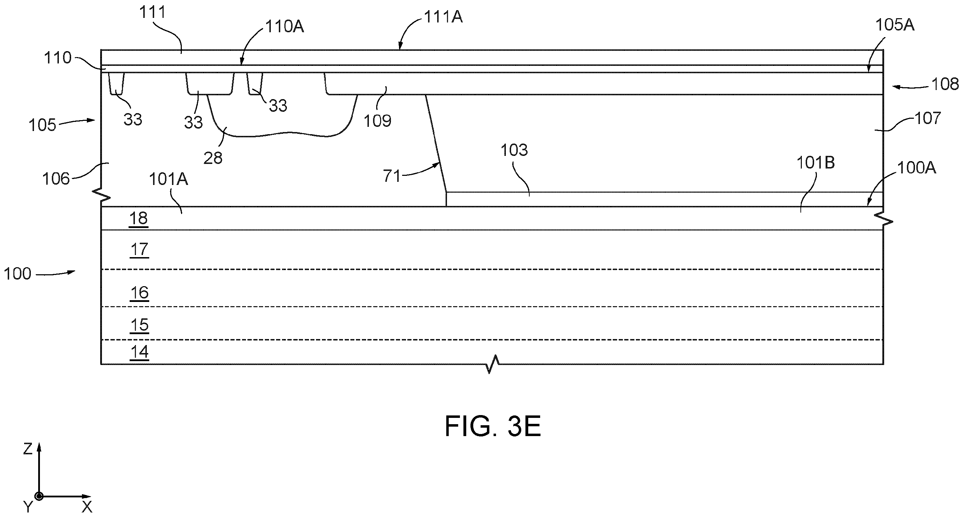

In Figure 3E, the doped region 28, corresponding to the body region of the NMOS transistor 5B, and, optionally, an insulating layer 108 are formed in the surface layer 105.

In detail, the body region 28 is formed in the epitaxial portion 106, where the silicon-based components 5 are formed.

The body region 28 may be formed via implantation of dopant ions.

The insulating layer 108, for example of silicon oxide, forms the insulating portions 33 (Figure 1) and a portion 109 that is intended to form the insulation region 77 (Figure 1).

The insulating layer 108 may be obtained via formation of insulation trenches in the surface layer 105, for example shallow-trench insulation (STI). In this case, the thickness of the epitaxial portion 106 and of the sacrificial portion 107 may be reduced as a result of formation of the insulating layer 108.

Furthermore, once again with reference to Figure 3E, one or more surface layers 110 may be formed on the top surface 105A of the surface layer 105, according to the specific silicon-based electronic components 5 that are intended to be integrated in the die 3 of the device 1.

In the embodiment illustrated, the surface layers 110 are layers that are intended to form the insulated-gate regions 40, 41 (Figure 1) of the PMOS and NMOS transistors 5A, 5B. In particular, of the surface layers 110, just a single gate layer, here of polysilicon, is illustrated here and is still designated by 110. However, an oxide layer (here not illustrated) is formed in a per se known manner between the top surface 105A and the polysilicon layer 110.

The polysilicon layer 110 has a top surface 110A.

On the surface 110A of the gate layer 110, a sacrificial mask layer 111 having a top surface 111A is also formed, for example of insulating material, for instance a single insulating layer or an insulating multilayer comprising for instance one or more of silicon oxide, silicon nitride, aluminium oxide, and silicon carbide.

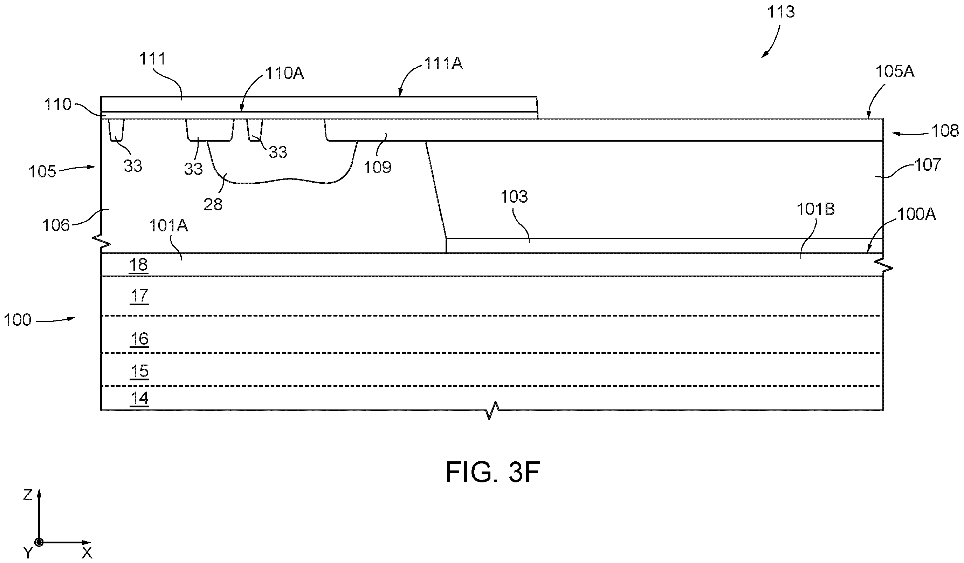

In Figure 3F, an opening 113 is opened above the sacrificial portion 107.

The opening 113 is formed by selectively removing part of the layers 110, 111, thus exposing the underlying sacrificial portion 107.

The remaining portion of the sacrificial layer 111 may be used as etch mask.

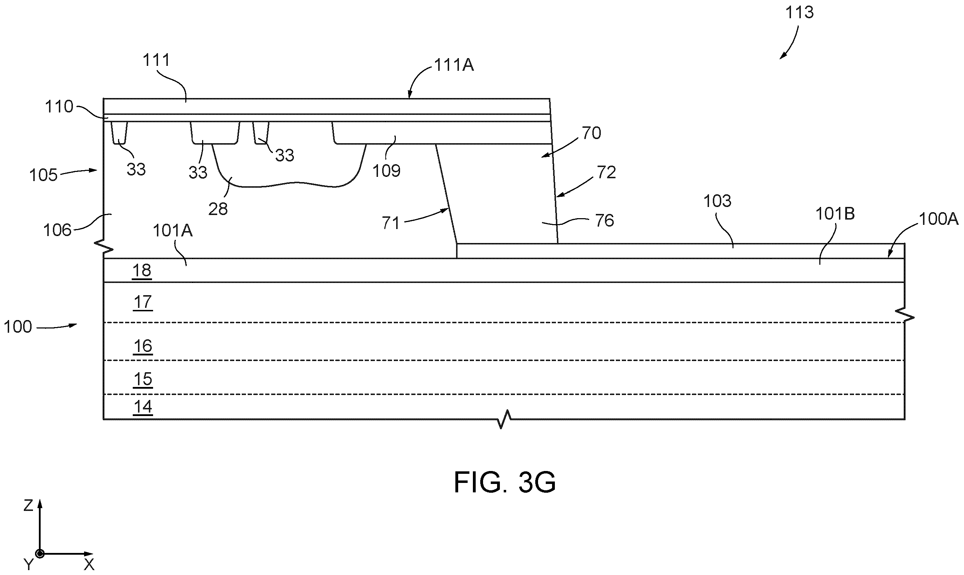

Then (Figure 3G), the insulating layer 108 and the sacrificial portion 107 are removed at the opening 113, using the etch mask 111.

Of the sacrificial portion 107 there thus remains the portion arranged underneath the etch mask, which will form the polycrystalline region 76 of Figure 1.

Following upon the etching of Figure 3G, the recess that has formed in the sacrificial portion 107 is continuous to the opening 113 and exposes part of the growth mask 103.

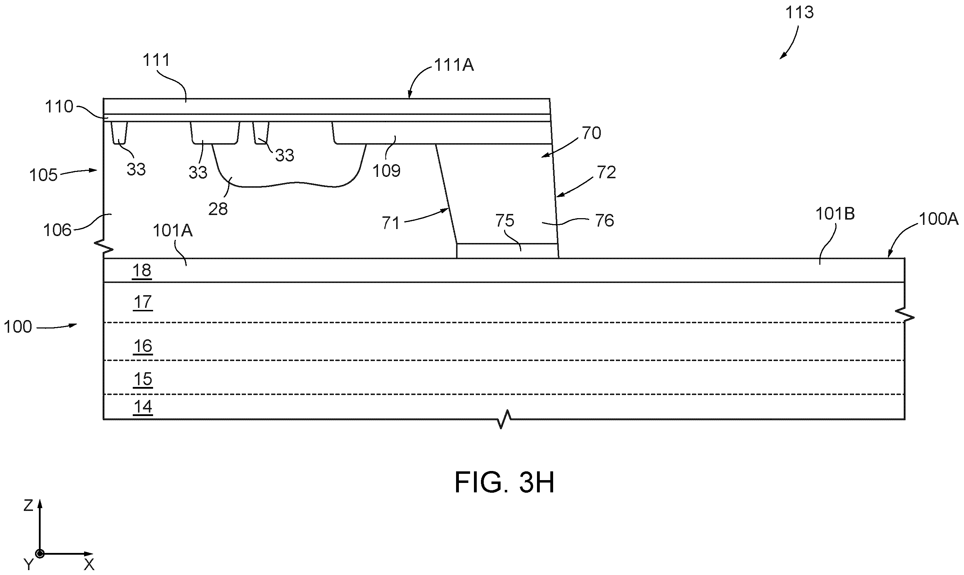

In Figure 3H, the exposed part of the growth mask 103 is removed. Of the growth mask 103 there thus remains the portion arranged underneath the polycrystalline region 76, i.e., the definition region 75 of Figure 1.

Etching of the exposed part of the growth mask 103 may be performed using a selective chemistry that does not etch, to a first approximation, the underlying second intermediate layer 18.

Following upon the etching of Figure 3H, the opening 113 thus exposes also the second portion 101B of the second intermediate layer 18.

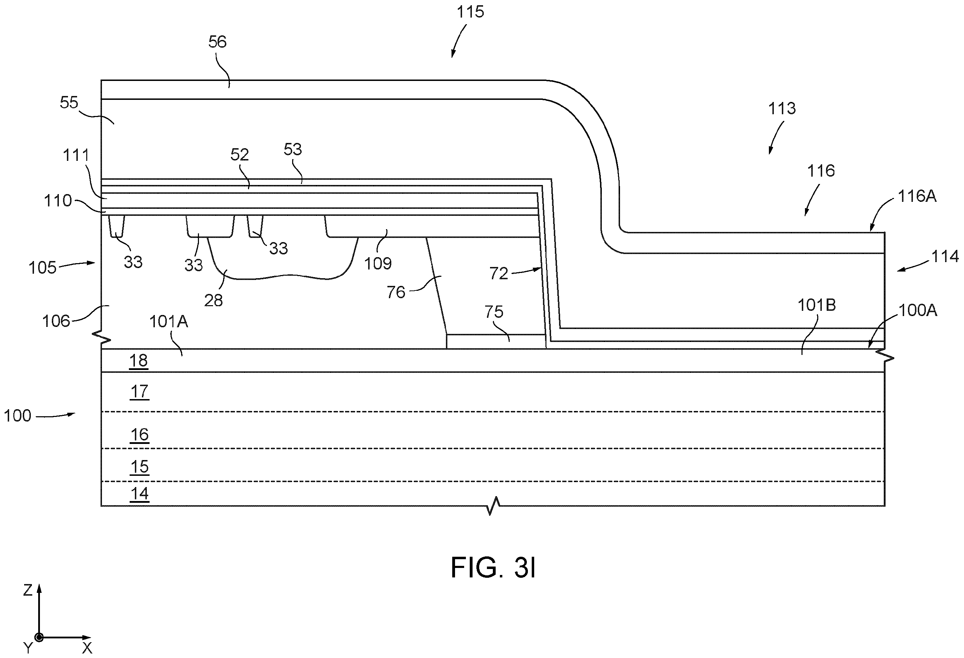

Next (Figure 3I), a working multilayer 114, which is intended to form the epitaxial multilayer 49 of Figure 1, is grown on the wafer 100.

In detail, a first buffer layer, corresponding to the buffer layer 52 of Figure 1 and consequently designated by the same reference number, is grown on the wafer 100. The first buffer layer 52 extends on the exposed portion of the top surface 100A, on the second side wall 72, and on the etch mask 111.

A second buffer layer, corresponding to the buffer layer 53 of Figure 1 and thus designated by the same reference number, is grown on the first buffer layer 52.

A channel layer, corresponding to the channel layer 55 of Figure 1 and thus designated by the same reference number, is grown on the second buffer layer 53.

A barrier layer, corresponding to the barrier layer 56 of Figure 1 and thus designated by the same reference number, is grown on the channel layer 55.

The working multilayer 114 comprises a raised portion 115, which extends on the etch mask 111 and on the second side wall 72 of the residual portion 70, and a useful portion 116 that extends directly on the top surface 100A of the second intermediate layer 18.

The useful portion 116 has a top surface 116A that is substantially planar, in particular substantially parallel to the top surface 100A.

The useful portion 116 grown on the second intermediate layer 18 is of a monocrystalline type and is used for integrating the heterostructure-based devices 7.

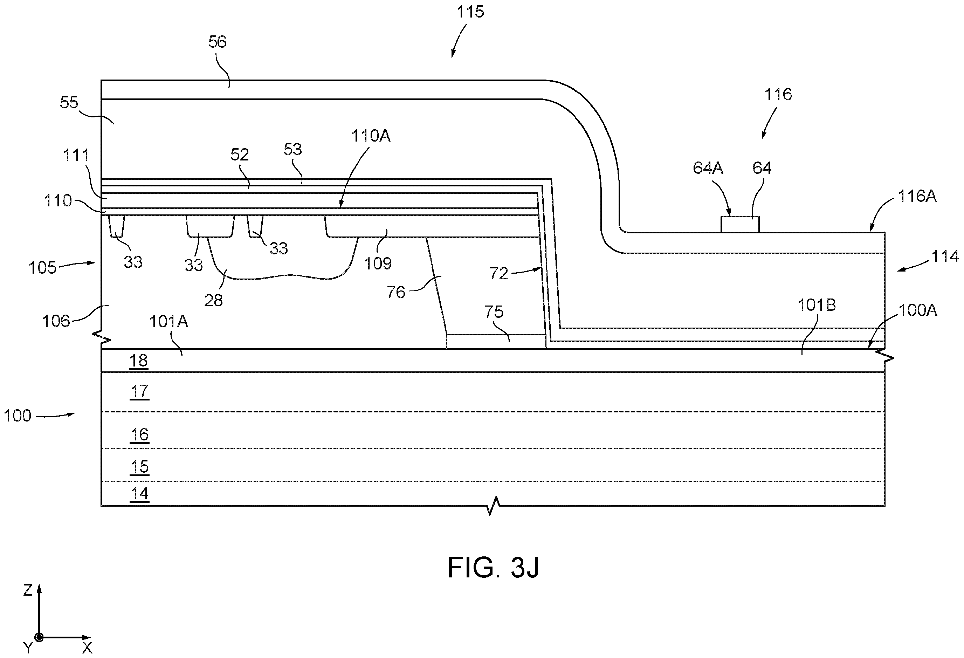

Then (Figure 3J), the channel-modulation region 64 is formed, in a per se known manner, for example via growth and definition of a specific layer, on the top surface 116A of the useful portion 116.

In practice, in this embodiment, the useful portion 116 of the working multilayer 114 also comprises the channel-modulation region 64.

Thus, here, the surface 64A of the modulation region 64 forms the most raised surface of the useful portion 116, i.e., the surface of the useful portion 116 at the greatest distance along the third axis Z from the surface 100A.

The surface 110A on which the etch mask 111 extends may be arranged at a distance, along the third axis Z, from the surface 100A, that is greater than that of the most raised surface of the useful portion 116 and smaller than that of the surface 110A. This may be useful in the subsequent manufacturing steps to protect the channel-modulation region 64 and thus increase the reliability of the process for manufacturing the device 1.

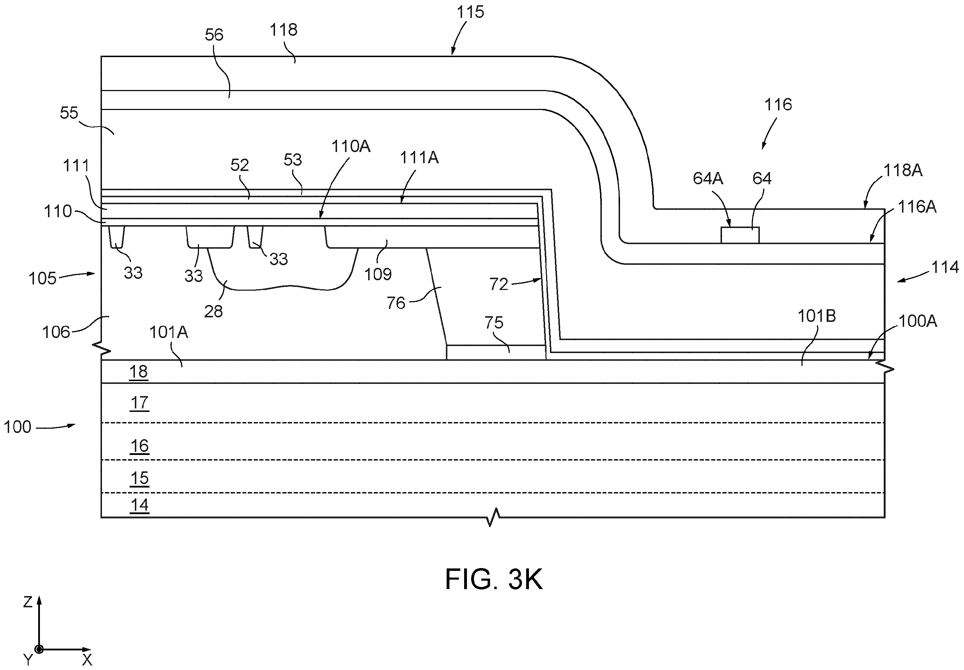

A protective layer 118 of insulating material, for example a single insulating layer or an insulating multilayer comprising for instance one or more of silicon oxide, silicon nitride, aluminium oxide, and silicon carbide, is formed (Figure 3K) on the barrier layer 56. The protective layer 118 has a thickness, along the third axis Z, comprised, for example, between 10 nm and 500 nm, greater than that of the channel-modulation region 64.

In other words, the protective layer 118 covers the channel-modulation region 64 completely.

The protective layer 118 has, at the useful portion 116, a top surface 118A that faces the top surface 116A of the useful portion 116.

In this embodiment, the top surface 118A of the protective layer 118 extends at a height, along the third axis Z, from the surface 100A that is less than the height, along the third axis Z, from the surface 100A, of the top surface 111A of the etch mask 111. This may be useful in the subsequent manufacturing steps to protect the channel-modulation region 64 and thus increase the reliability of the process for manufacturing the device 1.

Furthermore, in this embodiment, the distance along the third axis Z between the top surface 118A of the protective layer 118 and the top surface 64A of the channel-modulation region 64 is greater than the thickness, along the third axis Z, of the etch mask 111. This may be useful in the subsequent manufacturing steps to protect the channel-modulation region 64 and thus increase the reliability of the process for manufacturing the device 1.

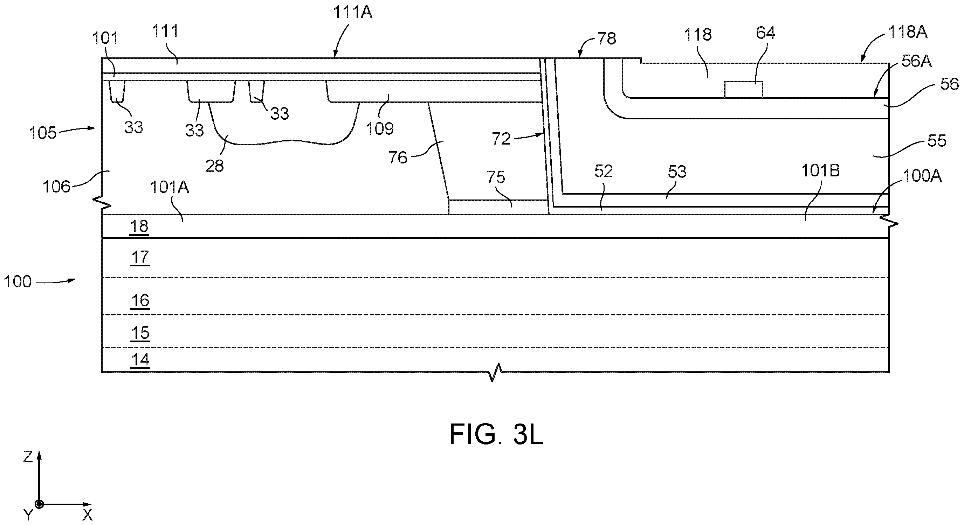

In Figure 3L, the raised portion 115 of the working multilayer 114 is removed, at least in part, up to the top surface 111A of the etch mask 111, thus exposing the etch mask 111.

Removal may be carried out via planarization, for example chemical-mechanical polishing (CMP) or other etching techniques.

In the embodiment illustrated, following upon removal, of the raised portion 115 of the working multilayer 114 there remains only the part extending over the second side wall 72, which forms the raised surface 78, flush with the top surface 111A of the etch mask 111.

Of the protective layer 118 there remains the portion, once again designated by 118, which extends on the useful portion 116 of the working multilayer 114.

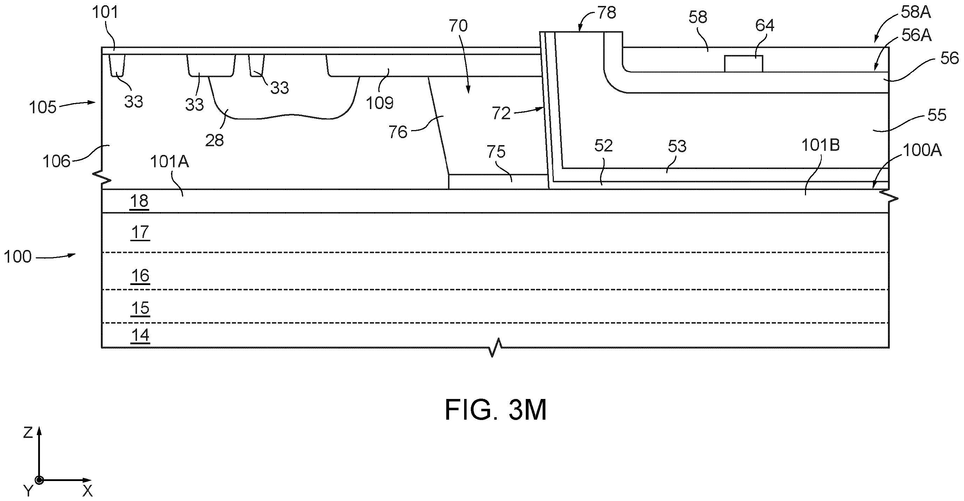

Then (Figure 3M), the wafer 100 is etched so as to remove the etch mask 111 and thus expose the gate layer 110.

In this embodiment, etching of the etch mask 111 also etches the protective layer 118, thus reducing the thickness thereof. However, since the thickness of the etch mask 111 is smaller than the distance between the top surface 64 of the channel-modulation region 64 and the top surface 118A of the protective layer 118, the remaining protective layer 118 still covers completely the channel-modulation region 64. Consequently, the channel-modulation region 64 may not get damaged by the etching operation represented in Figure 3M.

Following upon etching, the protective layer 118 forms the insulating layer 58 described with reference to Figure 1.

According to the materials forming the etch mask 111 and the protective layer 118 and of the specific etch used for removing the etch mask 111, the etching operation represented in Figure 3M may selectively remove only the etch mask 111 and not the protective layer 118.

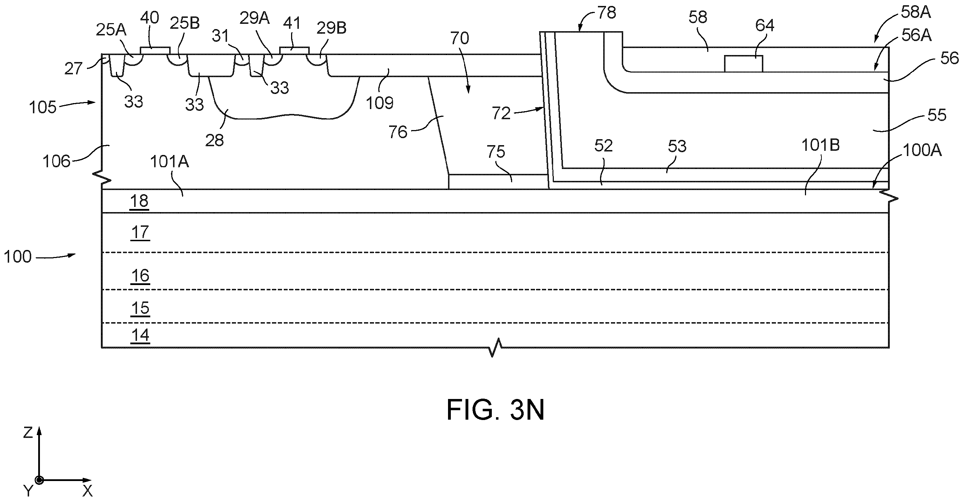

Next (Figure 3N), the gate layer 110 is defined, thus forming the insulated-gate regions 40, 41. Furthermore, the (heavily) doped regions 25A, 25B, 27, 29A, 29B, 31 are formed within the epitaxial portion 106 of the surface layer 105; for example, they may be defined with successive operations of masking and ion implantation.

Manufacturing steps follow, here not illustrated, for the formation of insulation and/or passivation layers of the wafer 100 (e.g., the oxide layers 35, 36 of Figure 1) and of the metal contact regions (e.g., the regions 42-45 and 61, 62, 65 of Figure 1) of the electronic components 5, 7.

There further follow final manufacturing steps (here not illustrated) such as formation of top layers of metal interconnection and dicing of the wafer, which lead to formation of the device 1.

The present manufacturing process allows to integrate, in a same die, both silicon-based electronic components 5 and heterostructure-based electronic components 7, obtaining a high crystallographic quality of the heterostructure 50.

In fact, use of the growth mask 103 allows at the same time both to grow the (monocrystalline) epitaxial portion 106, wherein the silicon-based electronic components 5 are formed, and to safeguarde the surface quality of the top surface 100A underneath the growth mask 103, on which the working multilayer 114 is grown.

The fact that the growth mask 103 comprises an oxide, in particular silicon oxide, enables the growth mask 103 to be etchable by chemical species different from the ones that may be used to remove the second intermediate layer 18. Consequently, the opening or recess 113, through the sacrificial portion 107, that exposes the underlying top surface 100A, may be formed without affecting, at least to a first approximation, the quality of the surface 100A, on which growing the epitaxial working multilayer 114 (Figures 3G-3I). In particular, the fact that the growth mask 103 includes a layer comprising oxide in direct contact with the semiconductor layer 18 may enable a further reduction of the risk of damage to the surface 100A on which to grow the epitaxial multilayer 49.

In particular, the fact that the growth mask 103 is of silicon oxide and the layer 18 is of silicon allows to obtain an etch rate of the growth mask 103 that is highly selective with respect to the silicon of the layer 18. Furthermore, it is also possible to use a wet etch to clean the surface 100A prior to growing the epitaxial working multilayer 114.

In practice, the growth mask 103 may be used as etch-stop layer during etching of the overlying sacrificial portion 107, thus guaranteeing complete removal of the overlying sacrificial portion 107. In addition, formation of the opening in the growth mask 103 does not adversely affect the quality, for example in terms of terracing and pitting, of the underlying surface 100A.

The epitaxial multilayer 49, and thus the heterostructure 50, may present a high crystallographic quality.

Consequently, the corresponding electronic components 7, whose functioning is based upon formation of the two-dimensional gas in the heterostructure 50, may have high electrical performance, in use.

At the same time, also the electronic components 5 are integrated in a monocrystalline-silicon layer (epitaxial portion 106) that may have a high crystallographic quality. Consequently, the electronic components 5 may have high electrical performance, in use.

Furthermore, the growth mask 103 may be sufficiently thick so as to be used as mask for forming the epitaxial multilayer 49 and, at the same time, sufficiently thin so as to minimize the non-planarity of the top surface 105A of the surface layer 105. In practice, the top surface 105A of the surface layer 105 may be considered substantially planar. This facilitates the subsequent manufacturing steps that lead to formation both of the silicon-based electronic components 5 and of the heterostructure-based electronic components 7.

The possibility of using the <111> silicon substrate 14 as starting substrate for forming the semiconductor electronic device 1 may allow to obtain a high epitaxial quality of the heterostructure 50, in particular when the channel layer 55 is GaN. Consequently, the heterostructure-based electronic components 7 may have excellent electrical performance. The present applicant has also found that the use of the <111> silicon substrate 14 also allows to obtain excellent electrical performance of the silicon-based electronic components 5.

With reference to the embodiment of the manufacturing process of Figures 3A-3N, the fact that some of the doped regions of the silicon-based devices 5, in particular those with a high doping level such as source regions, drain regions, and body-contact regions of the PMOS transistor 5A and NMOS transistor 5B, may be formed after growth of the epitaxial multilayer 49 may further contribute to increasing the reliability of manufacture of the device 1.

In fact, the epitaxial multilayer 49 may be grown using a thermal budget greater than the one that may be sustained by said heavily doped regions. In this way, the heavily doped regions of the silicon-based devices 5 may be formed with high reliability.

For instance, growth of the first buffer layer 52 of AlN may take place at a temperature of approximately 1100°C for a time interval comprised approximately between 15 and 30 minutes, and the growth of the GaN and AlGaN layers that form the second buffer layer 53, the channel layer 55, the barrier layer 56, and the channel-modulation region 64 may take place in successive growth steps each at a temperature of approximately 1030°C-1080°C for an interval of approximately 5-15 minutes.

However, it will be clear to the person skilled in the art that the manufacturing steps described above and the respective order of execution may differ from what has been illustrated in Figures 3A-3N, according to the specific processes and equipment used.

For instance, the epitaxial multilayer 49 may be grown prior to the surface layer 105.

For instance, the epitaxial multilayer 49 may be grown after formation of the heavily doped regions, according to the specific materials that form the epitaxial multilayer 49 and the epitaxial region 23.

For instance, the body regions of the NMOS and PMOS transistors may be formed prior to formation of the insulation oxide (33, 108) or else implanted after formation of the field insulation (STI); in particular, they are formed prior to formation of the oxide forming the gate structure of the PMOS and NMOS transistors, i.e., for example, prior to the deposition of the polysilicon layer 110.

For instance, the multilayer 114 may grow selectively only starting from the exposed portion 101B. In this case, the portion 115 would not be present; consequently, the removal represented in Figure 3L may be absent.

Finally, it is clear that other modifications and variations may be made to the electronic device 1 and to the corresponding manufacturing process described and illustrated herein, without thereby departing from the scope of the present invention, as defined in the annexed claims.

The electronic device 1 may comprise, in addition or as an alternative to the PMOS transistor 5A and NMOS transistor 5B, other silicon-based electronic components 5, active and/or passive, integrated in the die 3.

For instance, as illustrated in Figure 2, the silicon-based electronic components 5 may include also bipolar transistors 5C and passive components 5D such as diodes and resistors. In Figure 2, the bipolar transistors 5C and the passive components 5D are integrated in respective device portions 120, 121 that are distinct from one another and indicated schematically by a dashed line.

For instance, the device portions 120, 121 are formed in respective epitaxial regions of monocrystalline silicon grown on the substrate region 10, which in particular are monolithic with the epitaxial region 23.

Insulation regions, for example shallow or deep trenches, may be arranged, in a per se known manner, between the portions 120, 121 and 20 so that the respective electronic components are, in use, electrically insulated from one another.

The device 1 may also comprise other silicon-based electronic components 5 integrated in the die 3, in addition to or instead of those illustrated in Figure 2. For instance, the components 5 may include: MOS transistors for medium-voltage applications, for example from 15 V to 20 V; DMOS transistors and/or drift MOS transistors, for example for applications at operating voltages of from 20 V to 200 V; thin-film resistors; OTP or MTP memories; phase-change memories; etc.

It will be clear to the person skilled in the art that integration of silicon-based electronic components 5 of types different from one another may be obtained via manufacturing steps in themselves known and thus not illustrated further herein, for example using BCD technology.

For instance, the conductivity type, N or P, of the various semiconductive regions may be reversed as compared to what has been described.

For instance, the epitaxial multilayer 49 may comprise only the heterostructure 50. In other words, the heterostructure 50 may be grown directly on the substrate region 10.

For instance, the layers 14-18 may comprise one or more diffused regions of dopant species (P or N) according to the specific application.

For instance, the heterostructure-based components 7 may include electronic components other than the HEMT 7.

For instance, the HEMT 7 may be of a normally off type, wherein the gate structure may be different from what has been described previously; for example, the gate structure may be of a recessed type, and/or manufacturing of the gate structure may include the use of fluorine plasma underneath the gate structure. Alternatively, the HEMT 7 may be of a normally on type, i.e., of the depletion type.

For instance, with reference to Figure 1, the insulation region 77 that extends between the first and second device portions 20, 21 may have a shape and structure different from what has been illustrated. For example, there may be one or more trenches that extend along the third axis Z at a greater depth in the die 3.

For instance, the number of epitaxial layers that form the substrate region 10 may be different, according to the specific application.

For instance, according to the desired thicknesses, along the third axis Z, of the epitaxial multilayer 49 and of the epitaxial region 23, the second intermediate layer 18 may be absent, and the epitaxial multilayer 49 may be grown directly on the second deep layer 17.

In the case of medium-voltage or low-voltage applications (e.g., from 7 V to 40 V) the substrate region 10 may comprise only the substrate 14 and the first deep layer 15 (or also the first intermediate layer 16). In practice, in this case, the epitaxial multilayer 49 may be grown directly on the first deep layer 15 or, if present, on the first intermediate layer 16.

For instance, the electronic components 5 may be electronic components based upon a single semiconductor other than silicon, for example Ge, SiGe, etc.

## Claims

1. A manufacturing process of a semiconductor electronic device (1), comprising:
providing a wafer (100) comprising a substrate layer (18) of semiconductor material having a first portion (101A) and a second portion (101B) distinct from the first portion;
growing an epitaxial region (23, 106) of a single semiconductor material on the first portion (101A) of the substrate layer;
growing, on the second portion (101B) of the substrate layer, an epitaxial multilayer (49, 114) comprising a heterostructure (50);
forming a first electronic component (5A, 5B, 5C, 5D) based upon the single semiconductor material, starting from the epitaxial region (23, 106); and
forming a second electronic component (7) based upon the heterostructure, starting from the heterostructure,
wherein growing an epitaxial multilayer comprises:
forming a growth mask (103) on the substrate layer (18) ;
forming an opening in the growth mask (103), thereby exposing the second portion of the substrate layer; and
growing the epitaxial multilayer on the second portion of the substrate layer.

2. The manufacturing process according to the preceding claim, wherein the growth mask (103) is formed before growing the epitaxial region, the growth mask exposing the first portion (101A) of the substrate layer (18).

3. The manufacturing process according to claim 1 or claim 2, wherein growing the epitaxial region comprises growing a surface layer (105) of the single semiconductor material having a first portion (106) that extends over the first portion (101A) of the substrate layer (18) and a second portion (107) that extends over the growth mask (103); and wherein forming an opening in the growth mask (103) comprises forming, in the second portion (107) of the surface layer, a recess that extends up to the growth mask.

4. The manufacturing process according to the preceding claim, further comprising forming an etch mask (111) extending on the first portion (106) of the surface layer (105) and has an opening (113) on the second portion (107) of the surface layer (105),
wherein growing an epitaxial multilayer comprises: growing a work multilayer (114) having a first portion (116) extending on the second portion (101B) of the substrate layer (18) and a second portion (115) extending on the etch mask; and removing the second portion (115) of the work multilayer,
wherein the etch mask (111) extends in a direction (Z) from a surface (110A) that is arranged at a greater height, from the substrate layer (18) in the direction (Z), than the first portion (116) of the working multilayer.

5. The manufacturing process according to any one of the preceding claims, wherein the growth mask (103) comprises an oxide layer, for example silicon oxide.

6. The manufacturing process according to any one of the preceding claims, wherein the growth mask (103) has a thickness comprised between 7 nm and 300 nm.

7. The manufacturing process according to any one of the preceding claims, wherein forming a first electronic component (5A, 5B) comprises forming one or more doped regions (25A, 25B, 29A, 29B, 27, 31) in the epitaxial region (23, 106), after the step of growing an epitaxial multilayer.

8. The manufacturing process according to any one of the preceding claims, the first electronic component being a MOS transistor (5A, 5B) having an insulated-gate region (40, 41), wherein forming a first electronic component comprises forming an insulated-gate region (110) over the epitaxial region (23, 106), prior to the step of growing an epitaxial multilayer.

9. The manufacturing process according to any one of the preceding claims, wherein the single semiconductor material is silicon and the wafer (100) is of <111> silicon.

10. The manufacturing process according to any one of the preceding claims, wherein the single semiconductor material is silicon and the substrate layer (18) is a monocrystalline-silicon layer.

11. A semiconductor electronic device (1) comprising:
a die (3);
a first electronic component (5) based upon a single semiconductor material; and
a second electronic component (7) based upon a heterostructure,
wherein the die comprises:
a substrate region (10) of semiconductor material;
a first surface portion (20) comprising a monocrystalline region (23) of the single semiconductor material extending on the substrate region; and
a second surface portion (21) distinct from the first surface portion and comprising an epitaxial multilayer (49) extending on the substrate region, the epitaxial multilayer comprising a heterostructure (50),
the first electronic component (5) being integrated in the first surface portion of the die and the second electronic component (7) being integrated in the second surface portion of the die.

12. The device according to the preceding claim, wherein the die (3) further comprises a third surface portion (70) extending on the substrate region (10) between the first and the second surface portions, the third surface portion comprising a polycrystalline region (76) of the single semiconductor material, in particular monolithic with the monocrystalline region (23).

13. The device according to claim 11 or claim 12, wherein the first component is one of: a CMOS transistor, a DMOS transistor, a bipolar transistor, or a passive electronic component based upon the single semiconductor material.

14. The device according to any one of claims 11-13, wherein the second component is a high-mobility transistor (7), wherein the heterostructure is based upon materials of Groups III and V of the Periodic Table, for example comprising GaN.

15. The device according to any one of claims 11-14, wherein the substrate region (10) comprises a monocrystalline substrate (14) having a first conductivity type (P) and at least one epitaxial layer (15, 18) having a second conductivity type (N) different from the first conductivity type and extending on the substrate.
